# FASCICULE DE BREVET EUROPEEN

(11) **EP 0 675 441 B1**
(45) Date de publication et mention de la délivrance du brevet: **02.06.1999**
(21) Numéro de dépôt: 95400607.8
(22) Date de dépôt: 20.03.1995
(51) Int. Cl.: G06F 11/20

(54) **Dispositif matriciel de fusibles de redondance pour mémoire intégrée et procédé de mise en oeuvre**
Redundante Schmelzsicherungsmatrixanordnung für integrierten Speicher sowie Verfahren zu ihrem Betrieb
Redundancy fuses matrix array for integrated memory and implementing method

(30) Priorité: 31.03.1994 FR 9403845
(43) Date de publication de la demande: 04.10.1995
(73) Titulaire: STMicroelectronics S.A., 94250 Gentilly (FR)
(72) Inventeur: Rouy, Olivier, F-75116 Paris (FR); Gaultier, Jean-Marie, F-75116 Paris (FR)
(74) Mandataire: Ballot, Paul Denis Jacques

(56) Documents cités:
- EP-A- 0 058 049
- US-A- 4 546 454

## Description

L'invention concerne les mémoires réalisées en circuits intégrés du type non volatiles, effaçables et programmables électriquement et, plus particulièrement dans de telles mémoires, un dispositif matriciel de fusibles de redondance pour les mémoires de type "FLASH EEPROM".

Les mémoires sont commercialisées pour une capacité donnée, par exemple 16 mégabits pour une "FLASH EEPROM".

Or, les procédés de fabrication des circuits intégrés introduisent très souvent des défauts notamment ceux qui affectent les cellules mémoire. Aussi, pour éviter un trop grand nombre de rebuts, les fabricants de ces circuits prévoient un certain nombre de cellules redondantes destinées à remplacer le cas échéant des cellules défectueuses.

Généralement, les mémoires sont organisées en matrices formées de rangées et de colonnes de cellules mémoire.

Chaque cellule mémoire est alors sélectionnable par une ligne de mot associée à chaque rangée et une ligne de bit associée à chaque colonne. En pratique, pour des raisons de simplicité, le remplacement d'une cellule mémoire défectueuse est réalisé en remplaçant la totalité de la rangée ou de la colonne comportant cette cellule. L'élément de mémoire - rangée ou colonne - devant être remplacé dépendra du type de défaut détecté. Ces éléments redondants sont mis en service à la suite de tests effectués après la fabrication de chaque circuit intégré. A cet effet, des moyens de reconfiguration programmables sont prévus dans le circuit intégré de sorte que lorsque le test révèle un élément en défaut, ce dernier soit remplacé automatiquement par un élément de remplacement choisi parmi les éléments redondants et ce remplacement doit être invisible et sans conséquence sur les performances de la mémoire. En pratique, les moyens de reconfiguration contiennent des circuits pour détecter si l'adresse courante présente à la mémoire correspond à celle d'un élément en défaut et, si c'est le cas, ils sélectionnent un élément redondant en remplacement de l'élément en défaut.

Ce remplacement automatique est habituellement effectué au moyen de registres programmables non volatiles prévus pour contenir les adresses des éléments défectueux. Dans le cas d'une mémoire organisée en rangées et colonnes, cette adresse sera soit l'adresse de rangée, soit l'adresse de colonne. Pour réaliser ces registres programmables, on a utilisé et on utilise toujours ce qu'on appelle au sens large des "fusibles" : un fusible définit une information binaire selon son état (intact ou programmé) : pour chaque adresse défectueuse à enregistrer, on utilise une batterie de plusieurs fusibles, en nombre égal au nombre de bits servant à définir une adresse. Pour une adresse de p bits, il y a une batterie de p fusibles. L'état intact ou programmé des différents fusibles d'une batterie définit une adresse de p bits. S'il y a N lignes ou colonnes de redondance, c'est-à-dire si l'on veut pouvoir remplacer N lignes ou colonnes défectueuses par des lignes ou colonnes de remplacement, il faut N batteries.

En outre, à chaque batterie de fusibles est associé un fusible dit de validation qui a pour but d'indiquer si la batterie correspondante est utilisée ou non.

Lorsqu'on a besoin d'un élément de remplacement pour remplacer un élément défectueux, on stocke l'adresse de cet élément défectueux dans une batterie de fusibles et on "grille" un fusible de validation associé à cette batterie pour indiquer qu'elle est effectivement utilisée pour définir une opération de remplacement.

Les fusibles peuvent être des fusibles physiques (éléments de circuit ouvert qui est transformé en court-circuit lorsqu'il est grillé, ou le contraire); ou alors, plus fréquemment maintenant, les fusibles peuvent être des éléments de mémoire non volatiles tels que des transistors qui sont programmés et ne peuvent plus être effacés ensuite. L'état vierge ou intact du transistor correspond a un état original du "fusible"; l'état programmé du transistor correspond à un état grillé du fusible.

Jusqu'à présent, chaque élément redondant est associé à un tel registre ainsi qu'à un comparateur qui reçoit en entrées la valeur contenue dans ce registre et l'adresse courante. Lorsque les opérations de test sont terminées, on programme les registres à des valeurs représentatives des adresses des éléments défectueux. Ainsi, en fonctionnement, si l'adresse courante coïncide avec la valeur contenue d'un des registres, le comparateur associé délivre un signal permettant de sélectionner automatiquement l'élément redondant associé. Parallèlement, la sélection de l'élément défectueux est inhibée.

Cette solution nécessite donc de prévoir un nombre de registres programmables égal au nombre d'éléments redondants, chaque registre étant associé, par chiffre du code d'adresse, à un circuit de programmation et à un circuit de lecture, ce qui occupe une place non négligeable dans le circuit intégré.

Par ailleurs, il est nécessaire de programmer autant de registres que d'éléments défectueux détectés. Or la présence de registres programmables non volatiles pose des problèmes de fiabilité dus à la difficulté de leur fabrication et de leur programmation.

A ces registres programmables s'ajoutent des circuits de programmation et de lecture des fusibles de validation associés chacun à une batterie de fusibles, ce qui prend encore de la place sur le circuit intégré.

Aussi, l'invention a pour but de réaliser un dispositif matriciel de fusibles de redondance qui permet de réduire la place occupée par les circuits d'accès aux éléments redondants, et d'augmenter la fiabilité de l'ensemble.

L'invention concerne un dispositif de fusibles de redondance pour une mémoire à circuits intégrés selon la revendication 1.

Le document EP-A-0 058 049 décrit un dispositif de fusibles de redondance pour une mémoire à circuits intégrés tel que revendiqué dans le préambule de la revendication 1 mais ne décrit aucun moyen de lecture par colonne qui détecte la présence ou l'absence d'un courant dans cette colonne et qui fournit un signal de sélection de l'élément redondant associé à cette colonne lorsqu'aucun courant de colonne n'est détecté.

En outre, le circuit de programmation programme la colonne de cellules de mémoire afin de désactiver toutes les cellules de la colonne de mémoire si l'adresse de la mémoire à lire est la même que l'adresse de l'élément défectueux.

L'invention concerne également un procédé de remplacement d'un élément défectueux d'une mémoire à circuits intégrés par un élément redondant selon la revendication 6.

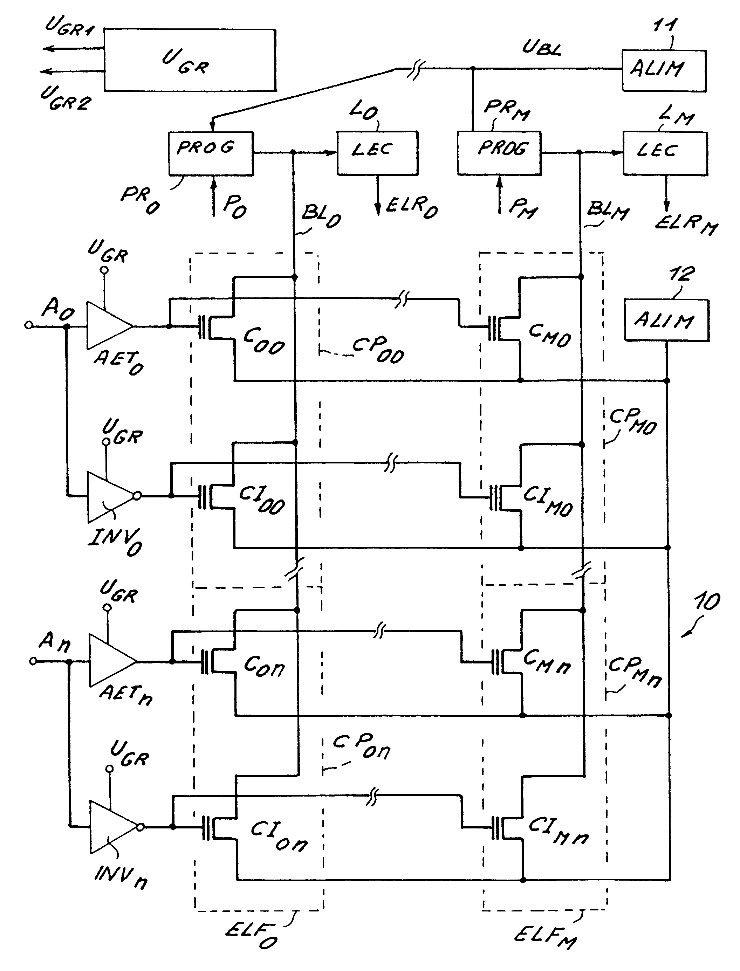

D'autres objets, caractéristiques et avantages de la présente invention apparaîtront à la lecture de la description suivante d'un exemple particulier de réalisation, ladite description étant faite en relation avec le dessin joint dans lequel la figure unique est un schéma d'un circuit redondant selon l'invention.

La mémoire intégrée incorporant un dispositif matriciel de fusibles de redondance selon l'invention peut comporter classiquement un réseau de lignes et colonnes de cellules adressables au moyen d'un décodeur de rangée et d'un décodeur de colonne. Le décodeur de rangée sert à désigner une rangée déterminée lorsqu'il reçoit une adresse de colonne et commande en conséquence un multiplexeur pour désigner un mot déterminé de la ligne sélectionnée. Le multiplexeur sélectionne alors des colonnes correspondant à ce mot et permet de connecter ces colonnes à des plots ou bornes d'entrée-sortie. Ces plots servent à transmettre, en lecture ou en écriture, un mot de données enregistrées dans la mémoire. Cette organisation, bien qu'elle ne soit pas le seule possible, est la plus généralement utilisée et sera prise comme base d'illustration de la présente invention.

Le circuit intégré de la mémoire comporte en outre un ensemble de circuits de redondance. Pour simplifier, on considère que les seuls éléments de redondance sont des colonnes de réparation destinées à remplacer des colonnes défectueuses. Mais il pourrait y avoir aussi des rangées de réparation pour remplacer des rangées défectueuses.

Il est prévu pour chaque colonne de réparation un dispositif d'aiguillage respectif. Ce circuit présente les fonctions suivantes :
- il possède en mémoire l'adresse de la colonne défectueuse;
- il reçoit les adresses de colonne appliquées à l'entrée de la mémoire;
- il reste inactif si l'adresse ne correspond à l'adresse enregistrée, et
- il aiguille la colonne de réparation vers les plots d'entrée-sortie à la place de la colonne défectueuse lorsqu'il reçoit l'adresse correspondant à la colonne défectueuse.

Selon l'invention, un dispositif matriciel de fusibles de redondance comprend, dans le cas d'un nombre (M+1) de colonnes de réparation, (M+1) colonnes ou batteries de fusibles ELF_{O} à ELF_{M}. Chaque batterie comporte autant de couples de fusibles que de chiffres A₀ à Aₙ du code d'adresse, soit (n+1) couples CP₀₀ à CP₀ₙ pour la colonne ELF₀ et (n+1) couples CP_{M0} à CP_{Mn} pour la colonne ELF_{M}.

Chaque couple de fusibles est constitué, par le couple CP₀₀, d'un premier transistor C₀₀ à grille flottante dont la grille reçoit le signal correspondant au chiffre A₀ du code d'adresse par l'intermédiaire d'un amplificateur élévateur de tension AET_{O} et d'un deuxième transistor CI₀₀ à grille flottante dont la grille reçoit, par l'intermédiaire d'un circuit inverseur INV₀, le même chiffre A₀ du code d'adresse, c'est-à-dire que la grille de CI_{OO} reçoit le signal du complément A₀. Chaque amplificateur AET_{O} à AETₙ et chaque circuit inverseur INV₀ à INVₙ est connecté à un générateur de tension U_{GR} qui fournit deux tensions, l'une de programmation U_{GR1} = 12 volts et l'autre de lecture U_{GR2} = 5 volts. Chaque chiffre A₀ à Aₙ du code d'adresse est appliqué aux grilles des couples des colonnes qui sont alignées suivant une rangée.

Les sources de tous les transistors sont connectées à un premier circuit d'alimentation 12 tandis que les drains des transistors d'une colonne sont connectés à un deuxième circuit d'alimentation 11 par l'intermédiaire d'un circuit de programmation. Chaque colonne est ainsi connectée, d'une part, à un circuit de programmation PR₀ à PR_{M} et, d'autre part, à un circuit de lecture L_{O} à L_{M}. Chaque circuit de programmation est commandé par un signal de programmation P_{O} à P_{M} qui indique l'information à enregistrer dans les transistors des couples. Chaque circuit de lecture fournit un signal ELR_{O} à ELR_{M} qui est appliqué au circuit de décodage colonne pour sélectionner la colonne de réparation à la place de la colonne défectueuse.

La description qui vient d'être faite montre qu'il n'y a qu'un seul circuit de programmation et un seul circuit de lecture par colonne ou batterie ELF_{O} à ELF_{M} alors que dans les dispositifs de l'art antérieur, il y a un circuit de programmation et un circuit de lecture par fusible. En outre, il n'y a pas de fusible de validation par batterie ni de circuit de programmation et de lecture d'un tel fusible. Il en résulte une réduction du nombre des transistors et donc un gain de place. Il est à noter cependant que le dispositif de l'invention comprend deux transistors par fusible et un inverseur par chiffre d'adresse mais cette augmentation est très inférieure à la réduction indiquée ci-dessus.

Le fonctionnement du dispositif de la figure unique sera maintenant expliqué en supposant que dans l'adresse de la colonne défectueuse, on a A₀ = 1 et Aₙ = 0̸ et que la colonne de remplacement correspond à la dernière colonne M.

La première opération est la programmation ou enregistrement de la colonne ELF_{M} qui consiste à avoir P_{M} = 1 alors que P₀ = 0̸, ce qui applique U_{BL} = 6 volts sur la colonne BL_{M} tandis que la colonne BL_{O} est flottante.

Par ailleurs, comme A_{O} = 1, un potentiel U_{GR1} = 12 volts est appliqué sur les grilles des transistors C_{OO} à C_{MO} de sorte que le transistor C_{MO} conduit et enregistre donc la valeur A_{O} = 1 si la colonne BL_{M} a a été sélectionnée par, le signal P_{M} appliqué au circuit de programmation PR_{M}. Par suite de l'inverseur INV_{O} et de la tension U_{GR1} = 12 volts, un potentiel zéro volt est appliqué aux grilles des transistors CI_{OO} à CI_{MO} de sorte que le transistor CI_{MO} reste bloqué.

Comme An = 0̸, un potentiel de zéro volt est appliqué aux grilles des transistors C_{On} à C_{Mn} de sorte que le transistor C_{Mn} reste bloqué. Par suite de l'inverseur INVₙ, un potentiel U_{GR1} = 12 volts est appliqué aux grilles des transistor CI₀ₙ à CI_{Mn} de sorte que le transistor CI_{Mn} conduit et enregistre la valeur Aₙ = 0̸.

Dans le cas où les batteries de fusibles sont adressées par un code de lecture de la mémoire présentant les chiffres A₀ = 1 et Aₙ = 0̸, les couples de cellules CP₀₀ à CP₀ₙ et CP_{MO} à CP_{Mn} se comportent de la manière suivante en supposant que U_{GR2} = 5 volts.

Lors de la lecture de la mémoire, le potentiel U_{GR1} = 5 volts est appliqué aux grilles des transistors C_{OO} à C_{MO} de sorte que le transistor qui a été programmé C_{MO} est bloqué. Le potentiel U_{GR2} = 5 volts est appliqué par l'intermédiaire de l'inverseur INV_{O} à tous les transistors CI_{OO} à CI_{MO} de sorte que le transistor CI_{MO} est bloqué.

Par ailleurs, un potentiel zéro volt est appliqué à toutes les grilles des transistors C₀ₙ à C_{Mn} de sorte que le transistor C_{Mn} est bloqué.

Lors de la lecture de la mémoire, le potentiel U_{GR1} = 5 volts est appliqué à toutes les grilles des transistors CI₀ₙ à CI_{Mn} de sorte que le transistor CI_{Mn} qui a été programmé est bloqué.

Il en résulte que tous les transistors de la colonne ELF_{M} qui ont enregistré le code de la colonne défectueuse, que le chiffre soit 0̸ ou 1, restent bloqués lorsqu'on leur applique le code en lecture et il n'y a donc pas de courant dans le conducteur BL_{M}. Le circuit de lecture L_{M} ne détecte pas de courant et fournit un signal ELR_{M} qui active la colonne de remplacement d'ordre M.

Dans toutes les autres colonnes, il y a au moins un chiffre du code d'adresse qui est différent de celui enregistré dans la colonne ELF_{M} de sorte qu'au moins un transistor sera conducteur et son courant sera détecté par le circuit de lecture associé. La colonne de remplacement correspondante ne sera pas sélectionnée.

Il est à remarquer que s'il n'y a pas d'élément défectueux dans la mémoire, aucune cellule du dispositif de redondance ne sera programmée et un courant sera détecté lors de la lecture; en conséquence, aucun remplacement ne sera effectué.

Du schéma de la figure unique, il apparaît que l'ensemble des batteries de fusibles se présentent sous la forme de cellules de mémoire organisées en rangées et colonnes comme dans une mémoire du type classique mais dans laquelle les rangées sont groupées deux par deux pour leur adressage. Il est à remarquer que, comme dans une mémoire classique, chaque conducteur de colonne BL_{O} à BL_{M} est connecté à un circuit de programmation PR_{O} à PR_{M} et à un circuit de lecture L_{O} à L_{M}, ces circuits étant identiques à ceux utilisés dans une mémoire classique. Pour réaliser le dispositif de l'invention, il est possible d'utiliser les cellules de la mémoire pour laquelle le dispositif de la présente invention est prévu ainsi que ses circuits associés tels que les circuits de programmation et de lecture.

L'invention concerne également un procédé de remplacement d'un élément défectueux d'une mémoire à circuits intégrés par un élément redondant, ledit élément défectueux et ledit élément redondant comprenant un élément d'une rangée d'une colonne de cellules de mémoire, le procédé comprenant les étapes consistant à :
- détecter une cellule défectueuse dans une des rangées et colonnes de cellules de mémoire ;
- programmer une colonne redondante de cellules de mémoire avec un code d'adresse d'un élément défectueux ;
- recevoir une adresse d'un élément de mémoire à lire ;
- désactiver toutes les cellules de mémoire de la colonne redondante si l'adresse de la mémoire à lire est la même que l'adresse de l'élément défectueux ;
- détecter qu'aucun courant n'existe dans la colonne redondante, et
- produire un signal de sélection pour le remplacement de l'élément défectueux par l'élément redondant quand aucun courant n'est détecté dans l'élément redondant.

Ce procédé peut être complété par une étape de maintien en condition inactive si l'adresse de la mémoire à lire n'est pas la même que l'adresse de l'élément défectueux.

Il peut aussi comprendre une étape supplémentaire consistant à coupler la colonne redondante avec des contacts respectifs de la mémoire si l'élément redondant doit remplacer l'élément défectueux ;

Dans ce procédé, l'étape de programmation d'une colonne redondante de cellules de mémoire avec une adresse comprend en outre l'étape consistant à rendre conducteur un premier transistor à effet de champ et à bloquer un deuxième transistor à effet de champ, constituant une paire de transistors à effet de champ, pour chaque rangée de la colonne redondante.

L'étape de désactivation de toutes les cellules de mémoire de la colonne redondante comprend en outre l'étape de blocage d'un premier transistor à effet de champ et de blocage d'un second transistor à effet de champ, constituant une paire de transistors à effet de champ, pour chaque rangée de la colonne redondante.

Le procédé peut comprendre en outre l'étape de non-programmation d'une colonne redondante de cellules de mémoire avec un code d'adresse d'un élément défectueux si aucun élément défectueux n'existe dans la mémoire à circuits intégrés.

Enfin, il peut comprendre en outre l'étape de non désactivation de toutes les cellules de mémoire de la colonne redondante lorsqu'il n'existe aucun élément défectueux dans la mémoire à circuits intégrés.

## Revendications

1. Dispositif de fusibles de redondance pour une mémoire à circuits intégrés, ladite mémoire étant organisée en rangées et colonnes de cellules de mémoire et comportant plusieurs éléments redondants, un "élément" désignant une rangée ou une colonne, qui sont destinés à remplacer des éléments comportant au moins une cellule défectueuse, ledit dispositif de fusibles de redondance étant prévu pour enregistrer les adresses des éléments défectueux et pour sélectionner l'élément redondant qui doit remplacer l'élément défectueux lorsque l'adresse de ce dernier est reconnue, caractérisé en ce qu'il comprend par élément redondant :
- une colonne de cellules de mémoire (ELF₀, ELF_{M}) qui sont groupées deux à deux par couple (CP₀₀ ; CP₀ₙ), chaque cellule de mémoire (C₀₀ ; CI₀₀) d'un couple (CP₀₀) étant adressée soit directement par un chiffre du code d'adresse (C₀₀), soit par son complément (CI₀₀), lesdites colonnes de cellules de mémoire étant organisées sous forme matricielle de rangées et colonnes dont les rangées sont adressées par les codes d'adresses appliqués à ladite mémoire à circuits intégrés,
- un circuit de programmation (PR₀ à PR_{M}) par colonne dudit dispositif pour indiquer à ladite colonne que la colonne de la mémoire correspondant à ce code d'adresse comporte un élément défectueux, ledit circuit de programmation programmant ladite colonne de cellules de mémoire (ELF₀, ELF_{M}) afin de désactiver toutes les cellules de ladite colonne de mémoire (ELF₀, ELF_{M}) si l'adresse de la mémoire à lire est la même que l'adresse de l'élément défectueux, et
- un circuit de lecture (L₀ à L_{M}) par colonne dudit dispositif pour détecter la présence ou l'absence d'un courant dans ladite colonne, ledit circuit de lecture fournissant un signal de sélection de l'élément redondant associé à ladite colonne lorsqu'aucun courant de colonne n'est détecté.

2. Dispositif selon la revendication 1, caractérisé en ce que chaque cellule de mémoire est réalisée par un transistor à effet de champ à grille flottante dont le drain est connecté à la colonne, la grille est connectée aux bornes d'entrée pour recevoir les codes d'adresses et la source est connectée à un circuit d'alimentation (12).

3. Dispositif selon la revendication 2, caractérisé en ce qu'il comprend, en outre, un premier circuit d'alimentation (12) qui est connecté à la source de chacun des transistors à effet de champ à grille flottante du couple de chaque cellule de mémoire.

4. Dispositif selon la revendication 2 ou 3, caractérisé en ce qu'il comprend, en outre, un deuxième circuit d'alimentation (11) qui est connecté au drain de chacun des transistors à effet de champ à grille flottante par l'intermédiaire du circuit de programmation (PR₀ à PR_{M}) de chaque colonne de cellules de mémoire.

5. Dispositif selon l'une des revendications 2, 3 ou 4, caractérisé en ce qu'il comprend, en outre, un circuit inverseur (INV₀ à INVₙ) dont la borne de sortie est connectée à la grille de l'un des transistors à effet de champ à grille flottante de la cellule de mémoire et dont la borne d'entrée est connectée au chiffre correspondant du code d'adresse.

6. Procédé de remplacement d'un élément défectueux d'une mémoire à circuits intégrés par un élément redondant, ledit élément défectueux et ledit élément redondant comprenant un élément d'une rangée d'une colonne de cellules de mémoire, le procédé comprenant les étapes consistant à :
- détecter une cellule défectueuse dans une des rangées et colonnes de cellules de mémoire ;
- programmer , à l'aide du dispositif de fusible re redondance selon la revendication 1, une colonne redondante de cellules de mémoire (ELF₀, ELF_{M}) avec un code d'adresse d'un élément défectueux ;
- recevoir une adresse d'un élément de mémoire à lire ;
- désactiver toutes les cellules de mémoire de la colonne redondante si l'adresse de la mémoire à lire est la même que l'adresse de l'élément défectueux ;
- détecter qu'aucun courant n'existe dans la colonne redondante, et
- produire un signal de sélection pour le remplacement de l'élément défectueux par l'élément redondant quand aucun courant n'est détecté dans l'élément redondant.

7. Procédé de remplacement d'un élément défectueux selon la revendication 6, caractérisé en ce qu'il comprend en outre l'étape de maintien en condition inactive si l'adresse de la mémoire à lire n'est pas la même que l'adresse de l'élément défectueux.

8. Procédé de remplacement d'un élément défectueux selon la revendication 6, caractérisé en ce qu'il comprend en outre l'étape consistant à coupler la colonne redondante avec des contacts respectifs de la mémoire si l'élément redondant doit remplacer l'élément défectueux.

9. Procédé de remplacement d'un élément défectueux selon la revendication 6, caractérisé en ce que l'étape de programmation d'une colonne redondante de cellules de mémoire avec une adresse comprend en outre l'étape consistant à rendre conducteur un premier transistor à effet de champ et à bloquer un deuxième transistor à effet de champ, constituant une paire de transistors à effet de champ, pour chaque rangée de la colonne redondante.

10. Procédé de remplacement d'un élément défectueux selon la revendication 6, caractérisé en ce que l'étape de désactivation de toutes les cellules de mémoire de la colonne redondante comprend en outre l'étape de blocage d'un premier transistor à effet de champ et de blocage d'un second transistor à effet de champ, constituant une paire de transistors à effet de champ, pour chaque rangée de la colonne redondante.

11. Procédé de remplacement d'un élément défectueux selon la revendication 6, caractérisé en ce qu'il comprend en outre l'étape de non-programmation d'une colonne redondante de cellules de mémoire avec un code d'adresse d'un élément défectueux si aucun élément défectueux n'existe dans la mémoire à circuits intégrés.

12. Procédé de remplacement d'un élément défectueux selon la revendication 11, comprenant en outre l'étape de non-désactivation de toutes les cellules de mémoire de la colonne redondante lorsqu'il n'existe aucun élément défectueux dans la mémoire à circuits intégrés.

## Patentansprüche

1. Vorrichtung mit Redundanzsicherungen für einen integrierten Speicherschaltkreis, wobei der Speicher in Reihen und Spalten von Speicherzellen aufgeteilt ist und mehrere redundante Elemente umfaßt, ein "Element" eine Reihe oder eine Spalte bezeichnet, die dazu dienen, Elemente zu ersetzen, die wenigstens eine defekte Zelle enthalten, die Vorrichtung mit redundanten Sicherungen versehen ist, um die Adressen defekter Elemente abzuspeichern und das redundante Element auszuwählen, das das defekte Element ersetzen soll, wenn die Adresse des letzteren bekannt ist,
dadurch gekennzeichnet, daß
sie pro redundantem Element umfaßt:
- eine Spalte von Speicherzellen (ELF₀, ELF_{M}), die zu zweit paarweise gruppiert sind (CP₀₀; CP₀ₙ), wobei jede Speicherzelle (C₀₀; CI₀₀) eines Paares (CP₀₀) entweder direkt durch eine Ziffer des Adreßcodes (C₀₀) oder durch deren Komplement (CI₀₀) adressiert wird, wobei die Spalten der Speicherzellen in Matrixform mit Zeilen und Spalten unterteilt sind, bei denen die Zeilen durch die Adreßcodes adressiert werden, die an dem integrierten Speicherschaltkreis anliegen,
- einen Programmierschaltkreis (PR₀ bis PR_{M}) pro Spalte der Vorrichtung, um der Spalte anzuzeigen, daß die Spalte des Speichers, die diesem Adreßcode entspricht, ein defektes Element enthält, wobei der Programmierschaltkreis die Zellenspalte des Speichers (ELF₀, ELF_{M}) programmiert, um alle die Zellen der Speicherspalte (ELF₀, ELF_{M}) zu deaktivieren, wenn die Adresse des Speichers zum Lesen die gleiche wie die Adresse des defekten Elementes ist, und
- einen Leseschaltkreis (L₀ bis L_{M}) pro Spalte der Vorrichtung, um die Anwesenheit oder Abwesenheit eines Stroms in der Spalte zu erfassen, wobei der Leseschaltkreis ein Signal zur Auswahl des redundanten Elementes ausgibt, das mit der Spalte zusammenhängt, wenn kein Strom in der Spalte erfaßt wird.

2. Vorrichtung nach Anspruch 1, dadurch gekennzeichnet, daß jeder Speicherzelle aufgebaut ist aus einem Feldeffekttransistor mit floatendem Gate, dessen Drain mit der Spalte verbunden ist, dessen Gate mit Eingangsanschlüssen verbunden ist, um die Adreßcodes zu empfangen, und dessen Source mit einem Versorgungsschaltkreis (12) verbunden ist.

3. Vorrichtung nach Anspruch 2, dadurch gekennzeichnet, daß sie außerdem einen ersten Versorgungsschaltkreis (12) umfaßt, der mit der Source jedes der Feldeffekttransistoren mit floatendem Gate des Paares jeder Speicherzelle verbunden ist.

4. Vorrichtung nach Anspruch 2 oder 3, dadurch gekennzeichnet, daß sie außerdem einen zweiten Versorgungsschaltkreis (11) umfaßt, der mit dem Drain jedes der Feldeffekttransistoren mit floatendem Gate über den Programmierschaltkreis (PR₀ bis PR_{M}) jeder Spalte aus Speicherzellen verbunden ist.

5. Vorrichtung nach einem der Ansprüche 2, 3 oder 4, dadurch gekennzeichnet, daß sie außerdem einen Inverterschaltkreis (INV₀ bis INVₙ) umfaßt, deren Ausgangsanschluß mit dem Gate des einen Feldeffekttransistors mit floatendem Gate der Speicherzelle verbunden ist, und deren Eingangsanschluß mit der Ziffer verbunden ist, die dem Adreßcode entspricht.

6. Verfahren zum Ersetzen eines defekten Elementes eines integrierten Speicherschaltkreises durch ein redundantes Element, wobei das defekte Element und das redundante Element ein Element einer Reihe einer Spalte von Speicherzellen umfaßt, wobei das Verfahren die folgenden Schritte umfaßt:
- Erfassen einer defekten Zelle in einer der Zeilen und Spalten der Speicherzellen;
- Programmieren mit Hilfe der Vorrichtung mit redundanten Sicherungen nach Anspruch 1 einer redundanten Spalte aus Speicherzellen (LEF₀, ELF_{M}) mit einem Adreßcode eines defekten Elements;
- Empfangen einer Adresse eines zu lesenden Speicherelementes,
- Deaktivieren aller Zellen des Speichers der redundanten Spalte, wobei die Adresse des zu lesenden Speichers die gleiche ist, wie die Adresse des defekten Elements,
- Erfassen, daß kein Strom in der redundanten Spalte existiert, und
- Erzeugen eines Auswahlsignals zum Ersetzen des defekten Elementes durch das redundante Element, wenn kein Strom in dem redundanten Element erfaßt wird.

7. Verfahren zum Ersetzen eines defekten Elements nach Anspruch 6, dadurch gekennzeichnet, daß es außerdem den Schritt des Beibehaltens des inaktiven Zustandes umfaßt, wenn die Adresse des zu lesenden Speichers nicht die gleiche wie die Adresse des defekten Elementes ist.

8. Verfahren zum Ersetzen eines defekten Elementes nach Anspruch 6, dadurch gekennzeichnet, daß es außerdem den Schritt umfaßt, der darin besteht, die redundante Spalte mit jeweiligen Kontakten des Speichers zu verbinden, wenn das redundante Element das defekte Element ersetzen soll.

9. Verfahren zum Ersetzen eines defekten Elementes nach Anspruch 6, dadurch gekennzeichnet, daß der Schritt der Programmierung einer redundanten Spalte von Speicherzellen mit einer Adresse außerdem den Schritt umfaßt, der darin besteht, für jede Reihe der redundanten Spalte einen ersten Feldeffekttransistor leitend zu machen und einen zweiten Feldeffekttransistor zu sperren, die beide ein Paar von Feldeffekttransistoren bilden.

10. Verfahren zum Ersetzen eines defekten Elementes nach Anspruch 6, dadurch gekennzeichnet, daß der Schritt des Deaktivierens aller Zellen des Speichers der redundanten Spalte außerdem für jede Reihe der redundanten Spalte den Schritt des Sperrens eines ersten Feldeffekttransistors und des Sperrens eines zweiten Feldeffekttransistors umfaßt, die ein Paar von Feldeffekttransistoren bilden.

11. Verfahren zum Ersetzen eines defekten Elementes nach Anspruch 6, dadurch gekennzeichnet, daß es außerdem den Schritt der Nichtprogrammierung einer redundanten Spalte mit Speicherzellen mit einem Adreßcode eines defekten Elementes umfaßt, wenn kein defektes Element in dem integrierten Speicherschaltkreis existiert.

12. Verfahren zum Ersetzen eines defekten Elementes nach Anspruch 11, das außerdem den Schritt des Nichtdeaktivierens aller Speicherzellen der redundanten Spalte umfaßt, wenn kein defektes Element in dem integrierten Speicherschaltkreis existiert.

## Claims

1. A redundancy fuse device for an integrated circuit memory, said memory being organised in rows and columns of memory cells and having several redundant elements, an "element" designating a row or column, designed to replace elements having at least one defective cell, said redundancy fuse device being provided as a means of recording the addresses of defective elements and selecting the redundant element which should replace the defective element when the address of the latter is recognised, characterised in that for each redundant element it has:
- a column of memory cells (ELF₀, ELF_{M}) which are grouped two by two in pairs (CP₀₀; CP₀ₙ), each memory cell (C₀₀, CI₀₀) of a pair (CP₀₀) being addressed either directly by a digit of the address code (C₀₀) or by its complement (CI₀₀), said columns of memory cells being organised in a matrix formation of rows and columns, the rows of which are addressed by the address codes applied to said integrated circuit memory,
- a programming circuit (PR₀ to PR_{M}) for each column of said device to indicate to said column that the column in the memory corresponding to this address code has a defective element, said programming circuit programming said column of memory cells (ELF₀, ELF_{M}) in order to disable all the cells of said column of the memory (ELF₀, ELF_{M}) if the address of the memory to be read is the same as the address of the defective element and
- a read circuit (L₀ to L_{M}) for each column of said device to detect the presence or absence of a current in said column, said read circuit supplying a signal to select the redundant element associated with said column if no column current is detected.

2. Device as claimed in claim 1, characterised in that each memory cell consists of a floating gate field effect transistor, the drain of which is connected to the column, the gate being connected to the input terminals in order to receive the address codes and the source being connected to a power supply circuit (12).

3. Device as claimed in claim 2, characterised in that it also has a first power supply circuit (12) which is connected to the source of each of the floating gate field effect transistors of the pair of each memory cell.

4. Device as claimed in claim 2 or 3, characterised in that it also has a second power supply circuit (11) which is connected to the drain of each of the floating gate field effect transistors by means of the programming circuit (PR₀ to PR_{M}) of each column of memory cells.

5. Device as claimed in one of claims 2, 3 or 4, characterised in that it also has an inverter circuit (INV₀ to INVₙ), the output terminal of which is connected to the gate of one of the floating gate field effect transistors of the memory cell and the input terminal of which is connected to the corresponding digit of the address code.

6. A method of replacing a defective element in an integrated circuit memory with a redundant element, said defective element and said redundant element comprising an element of a row in a column of memory cells, the method comprising the following steps which consist in :
- detecting a defective cell in one of the rows and columns of memory cells;
- programming, by means of the redundancy fuse device claimed in claim 1, a redundant column of memory cells (ELF₀, ELF_{M}) with an address code of a defective element;
- receiving an address of a memory element to be read;
- disabling all the memory cells in the redundant column if the memory address to be read is the same as the address of the defective element;
- detecting that there is no current in the redundant column and
- producing a selection signal to replace the defective element with the redundant element if no current is detected in the redundant element.

7. A method of replacing a defective element as claimed in claim 6, characterised in that it also includes a step which consists in remaining in the inactive state if the memory address to be read is not the same as the address of the defective element.

8. A method of replacing a defective element as claimed in claim 6, characterised in that it also includes a step which consists in pairing the redundant column with the respective contacts of the memory if the redundant element has to replace the defective element.

9. A method of replacing a defective element as claimed in claim 6, characterised in that the step of programming a redundant column of memory cells with an address also incorporates a step whereby a first field effect transistor is rendered conductive and a second field effect transistor is blocked, forming a pair of field effect transistors, for each row of the redundant column.

10. A method of replacing a defective element as claimed in claim 6, characterised in that the step of disabling all the memory cells of the redundant column also includes a step whereby a first field effect transistor is blocked and a second field effect transistor is blocked, forming a pair of field effect transistors, for each row of the redundant column.

11. A method of replacing a defective element as claimed in claim 6, characterised in that it also includes a step whereby a redundant column of memory cells is not programmed with an address code for a defective element if no defective element exists in the integrated circuit memory.

12. A method of replacing a defective element as claimed in claim 11, which also incorporates a step whereby all the memory cells of the redundant column are not disabled if there is no defective element in the integrated circuit memory.
